# EUROPÄISCHE PATENTANMELDUNG

(11) **EP 0 921 558 A2**
(43) Veröffentlichungstag der Anmeldung: **09.06.1999**
(21) Anmeldenummer: 98122887.7
(22) Anmeldetag: 02.12.1998
(51) Int. Cl.: H01L 21/00

(54) **Optische Strahlungsmess-Vorrichtung**

(30) Priorität: 08.12.1997 DE 19754385; 24.06.1998 DE 19828135; 12.11.1998 DE 19852321
(71) Anmelder: STEAG AST Elektronik GmbH, 85551 Kirchheim (DE)
(72) Erfinder: Hauf, Markus, 89335 Ichenhausen (DE)

(57) **Zusammenfassung**

Bei einer optischen Vorrichtung mit wenigstens einem Strahlungsdetektor (10) zum Messen einer von wenigstens einer Strahlungsquelle (3) emittierten elektromagnetischen Strahlung wird die das Meßergebnis beeinträchtigende Hintergrundstrahlung dadurch verringert und das Meßergebnis verbessert und sicherer gestaltet, wenn ein in einem Kanalkörper (11) ausgebildeter Strahlungskanal (12) für den Strahlungsweg zwischen der Strahlungsquelle (3) und dem Strahlungsdetektor (10) vorgesehen ist.

## Beschreibung

Die Erfindung betrifft eine optische Vorrichtung mit wenigstens einem Strahlungsdetektor zum Messen einer von wenigstens zwei Strahlungsquellen emittierten elektromagnetischen Strahlung.

Vorrichtungen dieser Art sind beispielsweise in Zusammenhang mit Schnellheizöfen für die thermische Behandlung von Halbleitersubstraten zur Fertigung von Halbleiterchips bekannt. Um die Parameter und Eigenschaften, beispielsweise die Temperatur, die Emissivität, die Reflektivität, die Transmissivität und/oder die Eigenschaften oder Dicke einer während der thermischen Behandlung aufzubringenden Schicht auf das Halbleitersubstrat messen zu können, wird die von dem Halbleitersubstrat kommende Strahlung sowie die Strahlung gemessen, die von den zur Aufheizung des Halbleitersubstrats vorgesehenen Strahlungsquellen emittiert werden. Durch einen Vergleich der beiden gemessenen Strahlungswerte ist es möglich, zwischen der vom Halbleitersubstrat emittierten und reflektierten Strahlung zu unterscheiden. Vorrichtungen und Verfahren dieser Art sind beispielsweise aus der US 5 490 728 bekannt, bei denen Lichtleitungen verwendet werden, um die jeweilige Strahlung und insbesondere auch die von den Strahlungsquellen abgegebene Strahlung zu Strahlungsdetektoren zu führen. Die Eintrittsöffnungen dieser Lichtleiter weisen jedoch einen großen und undefinierten Öffnungswinkel auf, so daß auch relativ viel Hintergrundstrahlung aufgenommen wird und auf den Strahlungsdetektor fällt. Dadurch sagen die Meßwerte hinsichtlich der eigentlichen, von den Strahlungsquellen kommenden Strahlung - wenn überhaupt - nur wenig aus und sind nicht spezifisch.

Darüber hinaus ist aus der DE 93 12 231 eine Vorrichtung zum Messen von UV-Strahlung bekannt, bei der eine Photodiode zum Messen von einer Strahlungsquelle emittierten UV-Strahlung in einem zylindrischen Gehäuse mit einer Öffnung vorgesehen ist. Die Öffnung ist teilweise durch eine Meßblende, die einen Strahlungskanal bildet verschlossen.

Ferner sei auf die DE 31 29 065 verwiesen, welche ein Gerät zur photoelektrischen Überwachung eines Strömungsmediums aufweist, bei dem eine Lichtquelle und ein der Lichtquelle gegenüberliegender Direktlichtempfänger vorgesehen ist, der in einem Empfängerbus mit einem Lichtleitkanal angeordnet ist. Aus der DE 39 08 627 ist darüber hinaus ein Multielement-Infrarotdetektor bekannt, bei dem vor jedem Detektorelement ein Lichtleiter in der Form von in einer Kanalplatte ausgebildeten lichtleitenden Kanälen angeordnet ist, deren Abmessungen eine Dämpfung von Radarstrahlung bewirken. Vor der Kanalplatte ist darüber hinaus eine Blendenplatte angeordnet, welche mit den lichtleitenden Kanälen fluchtende Blendenöffnungen mit nicht reflektierenden Innenflächen aufweist. Aus der FR 2 707 005 ist schließlich eine halbkreisförmige Fotodetektoranordnung gezeigt, bei der in einem halbkreisförmigen Trägerkörper Lichtleitkanäle angeordnet sind, an deren Ende jeweils ein Fotodetektor vorgesehen ist.

Der Erfindung liegt daher die Aufgabe zugrunde, eine optische Strahlenmeßvorrichtung zu schaffen, die mit einfachen Mitteln eine wesentlich genauere Bestimmung der von den Strahlungsquellen emittierten elektromagnetischen Strahlung ermöglicht.

Ausgehend von einer optischen Strahlenmeßvorrichtung der eingangs genannten Art wird diese Aufgabe erfindungsgemäß durch separate in einem Kanalkörper ausgebildete Strahlungskanäle für den Strahlungsweg zwischen den Strahlungsquellen und dem für die Strahlungsquellen gemeinsamen Strahllungsdetektor gelöst. Die Strahlungskanäle sind dadurch sehr genau auf die Strahlungsquelle ausrichtbar, so daß keine oder nur ein unwesentlicher Anteil an Hintergrundstrahlung, die das Meßergebnis verfälschen würde, auf den Strahlungsdetektor auftrifft. Dadurch lassen sich die Parameter, Eigenschaften und Intensitäten der von den Strahlungsquellen emittierten elektromagnetischen Strahlung wesentlich genauer und zuverlässiger bestimmen.

Gemäß einer besonders vorteilhaften Ausführungsform der Erfindung weist der Strahlungskanal eine Querschnittsform auf, die der Form der Strahlungsquelle entspricht. Durch die Form des Kanalquerschnitts und deren Abmessungen ist eine genaue Anpassung des Strahlungskanals an die Strahlungsquelle möglich, so daß unabhängig von der Form der Strahlungsquelle die Hintergrundstrahlung zuverlässig ausblendbar ist.

Besonders vorteilhaft ist es, wenn der Strahlungskanal eine Querschnittsform aufweist, die auch bei einer Abweichung der Strahlungsquelle aus der Soll-Lage einen Strahlungsdurchgang zum Strahlungdetektor gestattet. Durch eine derartige Ausformung des Kanals wird erreicht, daß sich mechanische Änderungen oder Lageabweichungen der Strahlungsquelle, beispielsweise einer Lampenwendel, die etwa durch Schwingungen, Dejustage oder Deformationen, etwa während des Aufheizvorgangs, auftreten, nicht in Signaländerungen niederschlagen, die andernfalls das Meßergebnis und die Auswertung nachteilig beeinflussen könnten.

Besonders vorteilhaft ist es, wenn der Strahlungskanal bzw. wenigstens eine Wand des Strahlungskanals strukturiert ist, beispielsweise eine wellige, geriffelte oder ungleichmäßige Wandstruktur aufweist. Dadurch wird Strahlung, die nicht parallel zur Strahlungskanalachse einfällt, die also nicht von der Strahlungsquelle herrührt, auch nicht durch Reflexion auf den Strahlendetektor geführt, sondern absorbiert. Die strukturierte Kanalwand trägt daher zusätzlich dazu bei, daß unerwünschte und undefinierte Hintergrundstrahlung und Streulicht nicht auf den Strahlendetektor fällt und die Meßergebnisse verfälscht.

Sehr vorteilhaft ist weiterhin eine Ausführungsform der Erfindung, gemäß der der Strahlungskanal wenigstens eine die Querschnittsfläche des Strahlungskanals veränderbare Einrichtung aufweist. Durch Veränderung der Querschnittsfläche des Kanals kann die Intensität, mit der die von einer Strahlungsquelle abgegebene Strahlung auf den Strahlungsdetektor fällt, eingestellt werden, was insbesondere dann von Vorteil ist, wenn gemäß einer weiteren Ausführungsform der Erfindung bei Vorhandensein mehrerer Strahlungsquellen das Verhältnis der auf den Strahlendetektor auftreffenden Strahlung der jeweiligen Lampen untereinander durch Ändern der Querschnittsfläche des jeweiligen Kanals einstellbar ist. Eine besonders einfache Einrichtung zur Änderung der Querschnittsfläche des Kanals und damit der auf den Strahlungsdetektor fallenden Strahlungsintensität ist eine Schraube, die quer zur Strahlungsrichtung in den Strahlungskanal einschraubbar ist. Aber auch eine veränderbare Blende ist anwendbar.

Bei einigen Schnellheizsystemen für die thermische Behandlung von Halbleitersubstraten wird Kühlluft zwischen die Strahlungsquellen eingeblasen, um bestimmte Elemente, wie zum Beispiel eine Reaktionskammer, zu kühlen. Diese Kühlluft bewirkt jedoch, daß zwischen den Strahlungskanälen und den einzelnen Strahlungsquellen Strömungsturbulenzen auftreten, die zu Intensitätsschwankungen führen. Um diese Intensitätsschwankungen zu vermeiden, erstreckt sich der Kanalkörper mit dem bzw. den Strahlungskanäle(n) bis zu der bzw. den Strahlungsquelle(n).

Gemäß einer bevorzugten Ausführungsform kann der Strahlungskanal durch wenigstens ein lichtdurchlässiges, den Strahlungskanal verlängerndes Zwischenelement zwischen wenigstens einer Austrittsöffnung eines Strahlungskanals und einer zugeordneten Strahlungsquelle, verlängert werden, ohne daß der Kanalkörper bis kurz vor die Strahlungsquelle herangeführt werden muß. Vorteilhafterweise ist hierzu ein mehrere Strahlungskanäle verlängerndes, gemeinsames Zwischenelement vorgesehen. Gemäß einer bevorzugten Ausführungsform der Erfindung, wird als Verlängerung ein Quarz- oder Saphirstab verwendet, bei dem Reflexionen an den Innenwänden möglichst unterdrückt werden, damit nur das direkt von der Strahlungsquelle kommende Licht auf den Detektor fällt.

Gemäß einer besonders vorteilhaften Ausführungsform der Erfindung sind - wie bereits erwähnt - mehrere Strahlungsquellen nebeneinander angeordnet, und der Kanalkörper weist für jede Strahlungsquelle einen separaten, zum gemeinsamen Strahlungsdetektor hin verlaufenden Strahlungskanal auf. Die Strahlungen der einzelnen Strahlungsquellen werden dabei unter Ausschaltung von Hintergrundstrahlung und gegenseitiger Beeinflussung zuverlässig und sicher auf den gemeinsamen Strahlungsdetektor geführt, wodurch die Meßgenauigkeit erhöht werden kann. Wenn die Strahlungsquellen beispielsweise Einzellampen sind, die in einer Reihe nebeneinander in Form einer Lampenbank angeordnet sind, wie dies beispielsweise bei Schnellheizvorrichtungen zur thermischen Behandlung von Halbleitersubstraten der Fall ist, sind die Kanäle zwischen den Lampen und der gemeinsamen Strahlenquelle fächerartig im Kanalkörper ausgebildet.

Da die Lampen im wesentlichen in einer Reihe angeordnet sind, ist gemäß einer weiteren Ausgestaltung der Erfindung zwischen den dem Strahlungsdetektor zugewandten Enden der Strahlungskanäle und dem Strahlungsdetektor eine Zylinderlinse angeordnet, die die fächerförmig auf den Strahlungsdetektor zulaufende Strahlung der einzelnen Strahlungsquellen auf den Strahlungsdetektor fokussiert.

Die erfindungsgemäße Strahlenmeßvorrichtung ist mit großem Vorteil in Zusammenhang mit einem Schnellheizofen für die thermische Behandlung von Halbleitersubstraten einsetzbar.

Die Erfindung wird nachstehend anhand eines bevorzugten Ausführungsbeispiels bei Einsatz der Strahlenmeßvorrichtung in Zusammenhang mit einer Schnellheizofen für die thermische Behandlung von Halbleitersubstraten unter Bezugnahme auf die Figuren erläutert. Es zeigen:
- Fig. 1: einen Längsschnitt durch einen Schnellheizofen unter Verwendung der erfindungsgemäßen Strahlenmeßvorrichtung in schematischer Darstellung,
- Fig. 2: eine Querschnitt entlang der in Fig. 1 eingezeichneten Schnittlinie II-II,
- Fig. 3: eine Querschnittsdarstellung des in Fig. 1 und 2 dargestellten Strahlungskanal-Körpers in vergrößerter schematischer Querschnittsdarstellung,
- Fig. 4: eine Schnittdarstellung entlang der in Fig. 3 eingezeichneten Schnittlinie IV-IV,
- Fig. 5: eine Darstellung des Strahlungskanal-Körpers in teilweiser Schnittdarstellung und in Blickrichtung auf die den Lampen zugewandte schmale Seite des Strahlungskanal-Körpers und
- Fig. 6: eine vergrößerte Teildarstellung des Strahlungskanal-Körpers zur Erläuterung der Ausrichtung und Anordnung der Strahlungskanäle bezüglich einer Lampe,
- Fig. 7: eine vergrößerte Teildarstellung des Bereichs zwischen einer Austrittsöffnung eines Strahlungskanals und einer Strahlungsquelle, zur Erläuterung eines weiteren Ausführungsbeispiels der Erfindung.

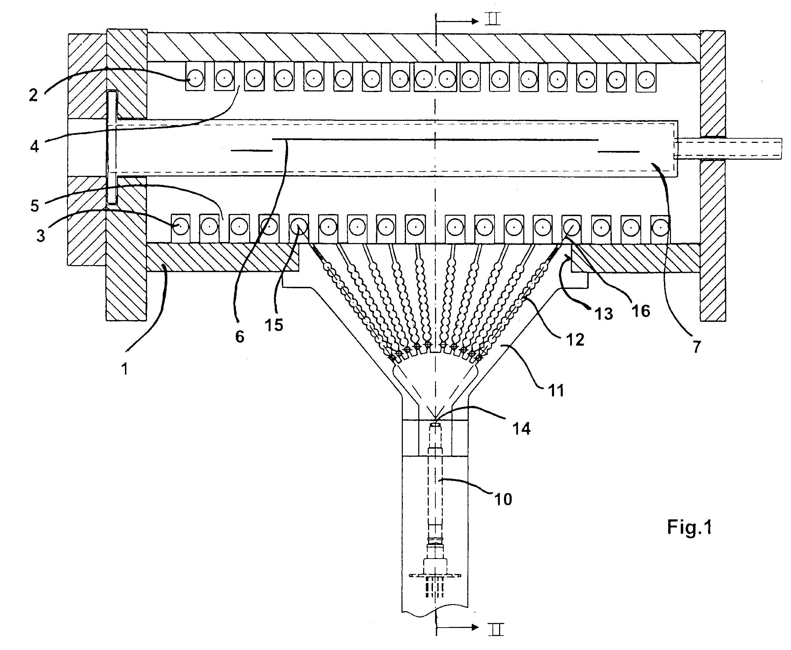

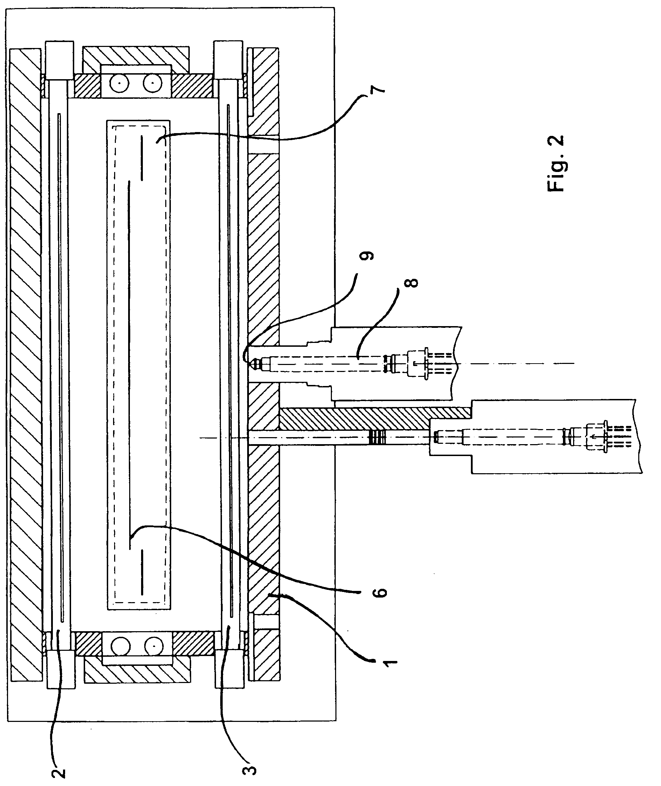

Der in Fig. 1 und 2 dargestellte Schnellheizofen weist ein Gehäuse 1 auf, an dessen oberer und unterer Innenwand jeweils eine aus mehreren Einzellampen oder Einzellampenröhren 2, 3 bestehende Lampenbank 4, 5 angebracht ist, die einen Halbleiterwafer 6 aufheizen, der in einer Reaktionskammer 7 zwischen den Lampenbänken 4, 5 im Gehäuse 1 angeordnet ist.

Vorteilhafterweise besteht die Reaktionskammer 7 im wesentlichen aus einem für die Lampenstrahlung im wesentlichen transparenten Material, das auch hinsichtlich der Meßwellenlängen oder der Meßwellenlängenspektren der Pyrometer oder der verwendeten Strahlungsdetektoren transparent ist. Mit Quarzgläser und/oder Saphir, die einen über das Lampenspektrum gemittelten Absorptionskoeffizienten von etwa 0.1 1/cm bis 0.001 1/cm haben, lassen sich geeignete Reaktionskammern für Schnellheizsysteme aufbauen, bei denen die Dicke der Reaktionskammerwand zwischen 1mm und mehreren Zentimetern, z.B. 5cm betragen kann. Je nach Reaktionskammerwanddicke kann die Materialauswahl hinsichtlich des Absorptionskoeffizienten erfolgen.

Kammerwanddicken im Zentimeterbereich sind insbesondere dann erforderlich, wenn in der Reaktionskammer 7 ein Unterdruck (bis hin zum Ultra-Hochvakuum) oder ein Überdruck erzeugt werden soll. Beträgt beispielsweise der Reaktionskammerdurchmesser etwa 300mm, so erhält man mit einer Quarzglasdicke von ca. 12mm bis 20mm eine hinreichende mechanische Stabilität der Kammer 7, so daß diese evakuiert werden kann. Die Reaktionskammerwanddicke wird entsprechend dem Wandmaterial, der Kammergröße und der Druckbelastungen dimensioniert.

Als Lampen werden bevorzugt Halogenlampen verwendet, deren Filament wenigstens teilweise eine Wendelstruktur aufweisen. Durch eine wenigstens teilweise Wendelstruktur läßt sich vorteilhaft ein bestimmtes vordefiniertes geometrisches und spektrales Abstrahlprofil der Lampe erreichen. Hierbei kann das Filament der Lampe z. B. abwechselnd gewendelte und ungewendelte Filamentabschnitte umfassen. Das Abstrahlprofil (sowohl das geometrische als auch das spektrale) ist in diesem Falle im wesentlichen durch den Abstand benachbarter gewendelter Filamentabschnitte bestimmt. Eine weitere Möglichkeit das Lampenabstrahlprofil zu definieren besteht z. B. darin, daß die Dichte der Filamentstruktur (z. B. der Wendeldichte) entlang des Filaments variiert wird.

Soll das Lampenprofil steuerbar sein, so lassen sich vorteilhaft Lampen, vorzugsweise Stablampen, mit mehreren einzelansteuerbaren Filamenten einsetzen. Lampen mit steuerbarem Lampenprofil sind insbesondere in Schnellheizanlagen zur Wärmebehandlung großflächiger Substrate, wie z. B. 300mm-Halbleiterwafer, vorteilhaft, da sich mit diesen Lampen und einer geeigneten Lampenansteuervorrichtung ein sehr homogenes Temperaturprofil entlang der Substratoberfläche erzielen läßt. Durch die Superposition der Einzelabstrahlprofile der Filamente ergibt sich ein in weiten Bereichen einstellbares Gesamtabstrahlprofil der Lampe. Im einfachsten Falle umfaßt z. B. eine Halogenlampe zwei Filamente, z. B. jeweils mit Wendelstruktur oder wenigstens teilweise gewendelter Struktur, wobei die Wendeldichte und/oder der Abstand der gewendelten Filamentabschnitte des ersten Filaments vom ersten Ende zum zweiten Ende der Lampe zunimmt, und die Wendeldichte und/oder der Abstand der gewendelten Filamentabschnitte des zweiten Filaments entsprechend umgekehrt vom ersten zum zweiten Ende der Lampe abnimmt. Das Gesamtabstrahlprofil kann somit durch die Wahl der Stromstärke in den beiden Filamenten in weiten Bereichen variiert werden.

Eine weitere Ausgestaltungsmöglickeit einer Lampe mit steuerbarem Abstrahlprofil besteht darin, daß das Filament der Lampe wenigstens drei elektrische Anschlüsse umfaßt, wobei jeweils zwischen den Anschlüssen untershiedliche Betriebsspannungen angelegt werden. Dadurch läßt sich abschnittsweise die Filamenttemperatur, und damit die Abstrahlcharakteristik der Lampe, entlang des Filaments steuern.

Alternativ zu den bisher beschriebenen Lampen lassen sich auch Plasma- oder Bogenlampen einsetzen, wobei auch hier das Abstrahlprofil einstellbar ist. So läßt sich beispielsweise das Lampenspektrum über die Stromdichte vom UV-Bereich bis hin zum nahen Infrarot einstellen.

Aus Fig. 2 ist ersichtlich, daß ein Wafer-Pyrometer 8, das auf der Unterseite des Gehäuses 1 angeordnet ist, über eine kleine Öffnung 9, die vorzugsweise, jedoch nicht notwenigerweise, im Zentrum des zu behandelnden Wafers 6 in einer Gehäusewandung ausgebildet ist, elektromagnetische Strahlung mißt, die vom Wafer 6 emittiert und reflektiert wird. Es ist jedoch auch möglich, mehrere, parallel zur Lampenachse angeordnete Wafer-Pyrometer zu verwenden.

Vorrichtungen der zuvor beschriebenen Art sind beispielsweise aus der US 5 490 728 bekannt. Darüberhinaus ist eine derartige Vorrichtung in der nicht vorveröffentlichten DE 197 37 802 A und in der dasselbe Anmeldungsdatum aufweisenden DE 197 54 386.3 derselben Anmelderin beschrieben, auf die zur Vermeidung von Wiederholungen Bezug genommen und die insofern zum Inhalt der vorliegenden Anmeldung gemacht werden.

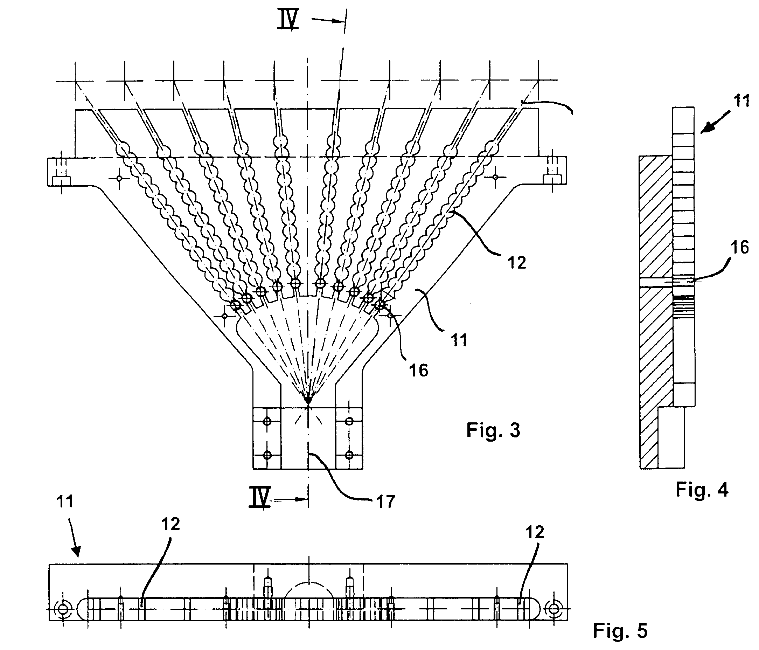

Auf der Unterseite des Schnellheizofens ist eine erfindungsgemäße optische Strahlungsmeßvorrichtung angeordnet, die ein Pyrometer 10 und einen Kanalkörper 11 umfaßt, in denen Strahlungskanäle 12 ausgebildet oder eingefräßt sind, wie dies im nachfolgenden anhand der Fig. 3 bis 5 noch im einzelnen erläutert werden wird.

Der Kanalkörper 11 weist entsprechend der Fig. 1 bis 5 im Längsschnitt eine Fächerform auf, die im Querschnitt scheiben- oder plattenförmig ist. Der Kanalkörper 11 ist in eine entsprechende Ausnehmung 13 in der oberen oder unteren Gehäusewand eingesetzt und mit dem Gehäuse 1 verschraubt. An der der Lampenbank 5 abgewandten Seite des Kanalkörpers 11 ist eine Linsenoptik 14, vorzugsweise eine Zylinderlinse so angeordnet, daß deren Brennpunkt sich an oder in der Nähe einer Stelle befindet, an der sich die Achsen der Strahlungskanäle 13 schneiden, so daß die auf die Linsenoptik 14 fallende Strahlung in das Pyrometer 10 gelangt.

Wie am besten aus Fig. 1 zu ersehen ist, sind die Strahlungskanäle 12 im Kanalkörper 11 so ausgebildet oder ausgerichtet, daß die jeweilige Wendel 15 der einzelnen Lampen 3 auf der verlängerten Längsachse 16 der jeweiligen Strahlungskanäle 12 liegen. Das Pyrometer 10 bzw. dessen Linsenoptik 14 "sieht" daher genau auf die jeweilige Lampenwendel 15, wodurch Hintergrundstrahlung, die nicht von der Lampenwendel 15 kommt, - wenn überhaupt - nur einen vernachlässigbar geringen Anteil am gesamten auf das Pyrometer 10 fallenden Lichtes ausmacht.

Der Kanalkörper 11 ist in Fig. 3 nochmals vergrößert dargestellt. Daraus ist zu entnehmen, daß die Wände der Strahlungskanäle 12 strukturiert, beispielsweise mit kleinen Auswölbungen versehen sind, die verhindern, daß Streustrahlung auf das Pyrometer 10 gelangt. Die Strahlungskanäle 12 mit entsprechender Strukturierung sind im Kanalkörper 11 durch Fräßen gebildet.

In der Nähe der dem Pyrometer 10 zugewandten Enden der Strahlungskanäle 12 befinden sich jeweils Schrauben 16, die in die Strahlungskanäle 12 mehr oder weniger weit einschraubbar sind und dadurch den Durchmesser der Strahlungskanäle 12 verändern, so daß die Intensität der durch den jeweiligen Strahlungskanal 12 hindurch gelangenden Strahlung veränderbar oder einstellbar ist. Dadurch ist es möglich, im wesentlichen jedes gewünschte Verhältnis zwischen den Strahlungsintensitäten der einzelnen Lampen 3, die auf das Pyrometer 10 fallen, einzustellen.

Vorausgesetzt, daß die Lampen jeweils dieselbe Strahlungsintensität aufweisen, gelangt über die der Mittelachse 17 des Kanalkörpers 11 am nächsten liegenden Strahlungskanäle 12 mehr Strahlungsintensität auf das Pyrometer 10 als über die weiter außen liegenden Strahlungskanäle 12. Um dies auszugleichen, kann der Kanalquerschnitt der weiter innen liegenden Strahlungskanäle 12 durch weiteres Einschrauben der Schrauben 16 verkleinert und dadurch die unterschiedliche, auf das Pyrometer 10 fallende Strahlungsintensität ausgeglichen werden. Auch ist jedes beliebige Verhältnis der Strahlungsintensitäten zueinander auf diese Weise einstellbar.

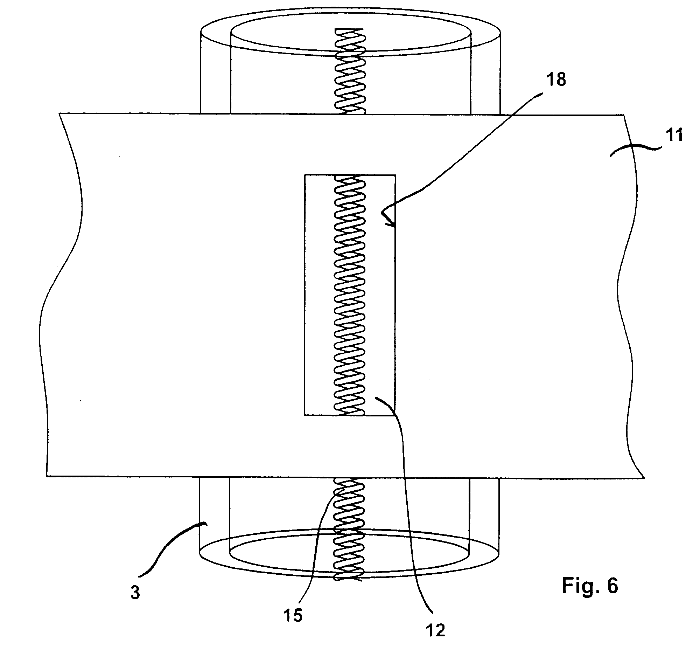

Wie am Ausführungsbeispiel gemäß Fig. 6 schematisch dargestellt ist, sind die Durchmesser oder Querschnitte der Strahlungskanäle 12 in optimaler Weise an die Form der Lampen 3 oder deren Wendeln 15 angepaßt, was dazu beiträgt, die Hintergrund- oder Streustahlung, die auf die Pyrometer 10 fällt, weiter zu verringern. Die Ausrichtung des Kanals 12 im Kanalkörper 11 bzw. das Kanalfenster im Kanalkörper 11 ist hinsichtlich der Abmessungen gemäß Fig. 6 so gewählt, daß die Wendel auch dann noch innerhalb des Kanalfensters 18 liegen, wenn die Wendel 15 vibriert oder schwingt, oder beispielsweise während des Aufheizvorgangs deformiert wird. Dadurch wird sichergestellt, daß die Lichtintensität, die auf das Lampenpyrometer 10 fällt, durch Schwingungen, Vibrationen oder Deformationen der Wendel 15 nicht verändert und die Messungen und Meßgenauigkeiten nicht beeinträchtigt werden.

Im allgemeinen sind die Strahlungsquellen und/oder die Strahlungskanäle bevorzugt so angeordnet, daß das Lampenpyrometersignal von einem Lampen- oder Filamentabschnitt resultiert, der frei von Filamenthaltevorrichtungen oder anderen, den Strahlungsfluß oder die Temperatur des durch die Strahlungskanäle beobachteten Filament- oder Lampenabschnitts beeinträchtigenden Mitteln ist.

Während das Lampenpyrometer 10 Linsenoptiken 14 mit Zylinderlinsen aufweist, kann das Waferpyrometer 8 mit einer Rundlinse 9, einer Zylinderlinse oder anderen linsenartigen Mitteln (z. B. Zonenplatten, Fressnellinsen) versehen sein, wobei die Mittel entsprechend der Strahlungsgeometrie der Lampen angepaßt sein können. Es ist z. B. vorteilhaft bei einer Lampenbank aus parallelen Stablampen eine Zylinderlinse mit parallel zu den Lampen ausgerichteter Zylinderachse zu verwenden. Im allgemeinen wird somit ein möglichst großer Raumbereich und damit z. B. eine hemisphärische Reflexion des Wafers 6 möglichst uneingeschränkt vermessen.

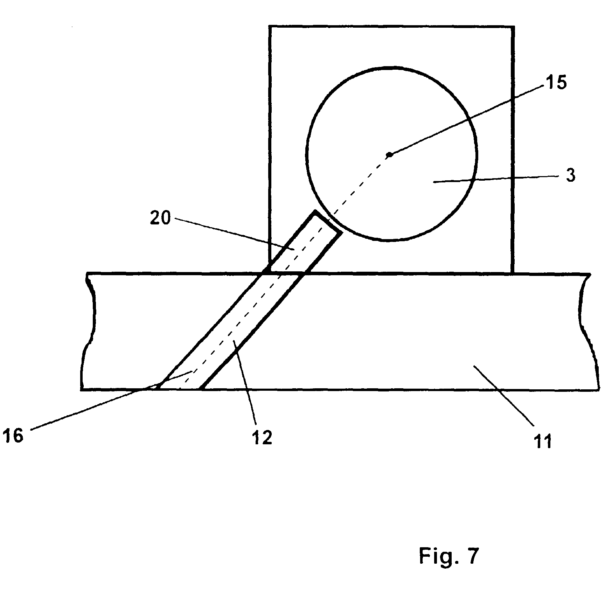

Figur 7 zeigt ein weiteres Ausführungsbeispiel der vorliegenden Erfindung, bei dem ein den Strahlungskanal 12 verlängerndes Zwischenelement 20, wie zum Beispiel ein Quarz- oder Saphirstab zwischen die Austrittsöffnung des Strahlungskanals 12 und die Lampe 3 eingesetzt ist. Dieses Element 20 dient dazu, den Strahlungskanal bis kurz vor die Lampe zu verlängern, wobei der Abstand zwischen dem Ende des Elementes und der Lampe nur wenige Millimeter beträgt. Dadurch wird verhindert, daß Strömungsturbulenzen, die zwischen der Austrittsöffnung des jeweiligen Kanals 12 und der zugeordneten Lampe 3 auftreten können, Intensitätsschwankungen bei der Messung erzeugen.

Obwohl das Verlängerungselement 20 als Stab dargestellt ist, ist es auch möglich, ein einziges Quarzelement über den gesamten Bereich des Fächers zwischen der Gehäusewand und den Lampen anzuordnen. Auch ist es möglich, den Fächer bis kurz vor die Lampen zu verlängern.

Die Erfindung wurde zuvor anhand eines bevorzugten Ausführungsbeispiels beschrieben. Dem Fachmann sind zahlreiche Abwandlungen und Ausgestaltungen möglich, ohne daß dadurch der Erfindungsgedanke verlassen wird. Beispielsweise ist die Anwendung der erfindungsgemäßen optischen Strahlungsmeßvorrichtung nicht auf Schnellheizsysteme für thermische Behandlung von Wafern beschränkt. Je nach den Anordnungen, Formen und Ausbildungen der Strahlungsquellen sind auch andere Kanalkörperformen als Fächerformen möglich. Auch die Ausbildung der Strahlungskanäle 14 ist nicht auf die in Fig. 3 dargestellten Ausführungsbeispiele beschränkt.

## Patentansprüche

1. Optische Vorrichtung, mit wenigstens einem Strahlungsdetektor (10) zum Messen einer von wenigstens zwei Strahlungsquellen (3) emittierten elektromagnetischen Strahlung, gekennzeichnet durch separate in einem Kanalkörper (11) ausgebildete Strahlungskanäle (12) für den Strahlungsweg zwischen den Strahlungsquellen (3) und dem für die Strahlungsquellen gemeinsamen Strahlungsdetektor (10).

2. Vorrichtung nach Anspruch 1, dadurch gekennzeichnet, daß der Strahlungskanal (12) eine Querschnittsform aufweist, die der Form der Strahlungsquelle (3) entspricht.

3. Vorrichtung nach Anspruch 1 oder 2, dadurch gekennzeichnet, daß der Strahlungskanal (12) eine Querschnittsform aufweist, die auch bei einer Abweichung aus der Soll-Lage der Strahlungsquelle (3) einen Strahlungsdurchgang zum Strahlungsdetektor (10) gestattet.

4. Vorrichtung nach einem der Ansprüche 1 bis 3, dadurch gekennzeichnet, daß wenigstens eine Wand des Strahlungskanals (12) strukturiert ist.

5. Vorrichtung nach einem der vorhergehenden Ansprüche, dadurch gekennzeichnet, daß der Strahlungskanal (12) wenigstens eine die Querschnittsfläche des Strahlungskanals (12) veränderbare Einrichtung (16) aufweist.

6. Vorrichtung nach Anspruch 5, dadurch gekennzeichnet, daß die die Querschnittsfläche des Strahlungskanals (12) veränderbare Einrichtung (16) eine Schraube umfaßt, die quer zur Strahlungsrichtung in den Strahlungskanal (12) einschraubbar ist.

7. Vorrichtung nach einem der vorhergehenden Ansprüche, dadurch gekennzeichnet, daß mehrere Strahlungsquellen (3) nebeneinander angeordnet sind und der Kanalkörper (11) für jede Strahlungsquelle (3) einen separaten zum gemeinsamen Strahlungdetektor (10) hin gerichteten Strahlungskanal (12) aufweist.

8. Vorrichtung nach einem der vorhergehenden Ansprüche, dadurch gekennzeichnet, daß sich der Kanalkörper (11) mit dem bzw. den Strahlungskanälen (12) bis zu der bzw. den Strahlungsquellen (3) erstreckt.

9. Vorrichtung nach einem der vorhergehenden Ansprüche, gekennzeichnet durch wenigstens ein lichtdurchlässiges, den Strahlungskanal (12) verlängerndes Zwischenelement (20) zwischen wenigstens einer Austrittsöffnung eines Strahlungskanals (12) und einer zugeordneten Strahlungsquelle (3).

10. Vorrichtung nach Anspruch 9, gekennzeichnet durch ein mehrere Strahlungskanäle (12) verlängerndes, gemeinsames Zwischenelement.

11. Vorrichtung nach einem der Ansprüche 9 oder 10, dadurch gekennzeichnet, daß das Zwischenelement (20) ein Quarz- oder Saphirelement ist.

12. Vorrichtung nach einem der Ansprüche 7 bis 11, dadurch gekennzeichnet, daß die Strahlungsquellen (3) Einzellampen sind, die in einer Reihe nebeneinander als Lampenbank (4, 5) angeordnet sind, und daß die Strahlungskanäle (12) zwischen den Lampen (3) und einem gemeinsamen Strahlungsdetektor (10) im Strahlungskörper (11) fächerartig ausgebildet sind.

13. Vorrichtung nach einem der Ansprüche 7 bis 12, dadurch gekennzeichnet, daß das Verhältnis der auf den Strahlungsdetektor (10) auftreffenden Strahlung der jeweiligen Lampen (3) untereinander durch die die Querschnittsfläche des jeweiligen Strahlungskanals (12) veränderbaren Einrichtung (16) einstellbar ist.

14. Vorrichtung nach einem der vorhergehenden Ansprüche, dadurch gekennzeichnet, daß zwischen den dem Strahlungsdetektor (10) zugewandten Enden der Strahlungskanäle (12) und dem Strahlungsdetektor (10) eine Zylinderlinse (14) angeordnet ist.

15. Vorrichtung nach einem der vorhergehenden Ansprüche, gekennzeichnet durch die Verwendung in Zusammenhang mit einem Schnellheizsystem für die thermische Behandlung von Halbleitersubstraten.

16. Vorrichtung nach Anspruch 15, dadurch gekennzeichnet, daß die thermische Behandlung der Halbleitersubstrate innerhalb einer Reaktionskammer erfolgt, die im wesentlichen aus einem, für die elektromagnetische Strahlung der Strahlungsquellen und für das Spektrum der Meßwellenlängen der Strahlungsdetektoren, transparenten Material besteht.

17. Vorrichtung nach Anspruch 16, dadurch gekennzeichnet, daß das transparente Material Quarzglas und/oder Saphir umfaßt.

18. Vorrichtung nach Anspruch 17 oder 16, dadurch gekennzeichnet, daß Material einen über das Lampenspektrum gemittelten Absorptionskoeffizienten zwischen 0.001 1/cm und 0.1 1/cm aufweist.

19. Vorrichtung nach einem der Ansprüche 16 bis 18, dadurch gekennzeichnet, daß die Wanddicke der Reaktionskammer zwischen 1mm und 5cm beträgt.

20. Vorrichtung nach einem der Ansprüche 1 bis 19, dadurch gekennzeichnet, daß die Strahlungsquellen wenigstens ein Filament mit wenigstens teilweise gewendelter Filamentstruktur umfassen.

21. Vorrichtung nach Anspruch 20, dadurch gekennzeichnet, daß durch die Filamentstruktur der Lampe ein vordefiniertes geometrisches und spektrales Abstrahlprofil erzielbar ist.

22. Vorrichtung nach Anspruch 21, dadurch gekennzeichnet, daß das Filament der Strahlungsquelle abwechselnd gewendelte und ungewendelte Filamentstrukturen umfaßt.

23. Vorrichtung nach einem der Ansprüche 21 bis 22, dadurch gekennzeichnet, daß die Strahlungsquelle zwei einzelansteuerbare Filamente umfaßt.

24. Vorrichtung nach einem der Ansprüche 20 bis 23, dadurch gekennzeichnet, daß wenigstens ein Filament wenigstens drei elektrische Anschlüsse umfaßt.

25. Vorrichtung nach einem der vorhergehenden Ansprüche, dadurch gekennzeichnet, daß die Strahlungsquelle wenigstens eine Halogenlampe umfaßt.

26. Vorrichtung nach einem der Ansprüche 20 bis 25, dadurch gekennzeichnet, daß die Dichte weigstens einer Filamentstruktur entlang des Filaments variiert.

27. Vorrichtung nach einem der Ansprüche 1 bis 19, dadurch gekennzeichnet, daß die Strahlungsquelle wenigstens eine Bogenlampe umfaßt.

28. Vorrichtung nach einem der vorhergehenden Ansprüche, dadurch gekennzeichnet, daß durch eine Anordnung der Strahlungsquelle und des Strahlungskanals relativ zueinander der Strahlungsdetektor ein Signal generiert, das frei von Einflüssen von Filamenthaltevorrichtungen oder anderer, den Strahlungsfluß oder die Strahlungstemperatur der Strahlungsquelle beeinträchtigender Mittel ist.
